(19) Europäisches Patentamt / European Patent Office / Office européen des brevets

(11) **EP 3 940 803 B1**

(12) **FASCICULE DE BREVET EUROPEEN**

(45) Date de publication et mention de la délivrance du brevet:
**14.05.2025 Bulletin 2025/20**

(21) Numéro de dépôt: **21185848.5**

(22) Date de dépôt: **15.07.2021**

(51) Classification Internationale des Brevets (IPC):
**H10N 70/20** *(2023.01)*

(52) Classification Coopérative des Brevets (CPC):
**H10N 70/8418; H10N 70/026; H10N 70/231; H10N 70/826; H10N 70/8828**

(54) **MATÉRIAU DESTINÉ À CHANGER DE PHASE ET MÉMOIRE RÉSISTIVE À CHANGEMENT DE PHASE ASSOCIÉE**

PHASENWECHSELMATERIAL UND ENTSPRECHENDER RESISTIVER PHASENWECHSELSPEICHER

PHASE-CHANGE MATERIAL AND ASSOCIATED RESISTIVE PHASE-CHANGE MEMORY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.07.2020 FR 2007416**

(43) Date de publication de la demande:
**19.01.2022 Bulletin 2022/03**

(73) Titulaire: **Commissariat à l'Energie Atomique et aux Energies Alternatives
75015 Paris (FR)**

(72) Inventeurs:
• **NAVARRO, Gabriele
38054 Grenoble Cedex 09 (FR)**
• **CYRILLE, Marie-Claire
38054 Grenoble Cedex 09 (FR)**

(74) Mandataire: **Cabinet Camus Lebkiri
25 rue de Maubeuge
75009 Paris (FR)**

(56) Documents cités:
**EP-A1- 3 608 979         WO-A1-2020/128487
US-A1- 2013 187 111**

• **SOUSA V ET AL: "Operation Fundamentals in 12Mb Phase Change Memory Based on Innovative Ge-rich GST Materials Featuring High Reliability Performance", 2015 SYMPOSIUM ON VLSI TECHNOLOGY, 16-18 JUIN 2015, KYOTO, JAPON, 2015, pages T98 - T99, XP033211404, ISSN: 0743-1562, DOI: 10.1109/ VLSIT.2015.7223708**

EP 3 940 803 B1

## Description

### DOMAINE TECHNIQUE DE L'INVENTION

Le domaine technique de l'invention est celui des matériaux pour mémoire à changement de phase et plus particulièrement celui des matériaux destinés à changer de phase pouvant être utilisés comme matériaux actifs de mémoires résistives à changement de phase.

La présente invention concerne un matériau destiné à changer de phase. La présente invention concerne également une mémoire résistive à changement de phase et des procédés de fabrication associés.

### ARRIERE-PLAN TECHNOLOGIQUE DE L'INVENTION

Les mémoires résistives à changement de phase ou mémoires PCM (pour « Phase-Change Memory ») sont des mémoires résistives comportant une zone active basée sur un matériau chalcogénure située entre deux électrodes. Le fonctionnement des mémoires PCM est basé sur la transition de phase du matériau chalcogénure, induite par l'échauffement de ce matériau sous l'effet d'impulsions électriques spécifiques appliquées via ses deux électrodes. Cette transition se fait entre une phase cristalline, de faible résistance et thermodynamiquement stable, appelée état LRS (pour « Low-Resistive State » dit autrement « SET ») et une phase amorphe, désordonnée, de résistance élevée et thermodynamiquement instable, appelée état HRS (pour « High-Resistive State dit autrement « RESET »).

Dans les applications automobiles, les mémoires PCM sont soumises pendant quelques minutes à des températures de l'ordre de 250°C et des années à des températures supérieures à 150°C. Pour préserver l'information stockée dans les mémoires PCM lors de leur fabrication et durant leur utilisation, celles-ci ne doivent pas cristalliser quand elles sont soumises à de telles températures : leur matériau actif doit donc avoir une température de cristallisation supérieure à 250°C.

Cependant, les matériaux constituant la couche active des mémoires PCM, tel que le matériau $Ge_2Sb_2Te_5$, sont sujets au phénomène de « drift » pour l'état LRS ou SET. Ce phénomène de « drift » correspond à une évolution dans le temps et sous l'effet de la température, de la résistance électrique du matériau en phase cristalline vers des valeurs de plus en plus élevées, pouvant se rapprocher de la résistance électrique du matériau à l'état HRS ou RESET, c'est-à-dire en phase amorphe. Les deux états résistifs LRS et HRS de la mémoire PCM peuvent alors ne plus être suffisamment distincts pour que la mémoire PCM fonctionne nominalement.

Il existe donc un besoin de fournir une mémoire PCM ayant une température de cristallisation élevée, et en particulier supérieure à 250°C, non sujette au phénomène de « drift » pour l'état LRS ou SET.

Le document US 2013/187111 A1 intitulé « Memory cells » est connu de l'état de la technique. La composition de chalcogénure GeSbTe de la couche active de la mémoire PCM peut contenir (Fig. 7) de 52 à 80 % d'atomes de Ge, de 2 à 28 % d'atomes de Te et de 10 à 34 % d'atomes de Sb, de préférence $Ge_{61}Sb_{22}Te_{17}$ ou $Ge_{63}Sb_{25}Te_{12}$.

### RESUME DE L'INVENTION

L'invention offre une solution aux problèmes évoqués précédemment, en permettant d'obtenir une mémoire PCM cristallisant à une température notamment compatible avec une application automobile ou embarquée, c'est-à-dire supérieure à 250°C, avec un état LRS ou SET ayant une résistance évoluant peu dans le temps.

Un premier aspect de l'invention concerne un matériau destiné à changer de phase comportant du germanium Ge, du tellure Te et de l'antimoine Sb, comportant au moins 37% de germanium Ge, le rapport entre la quantité d'antimoine Sb et la quantité de tellure Te étant compris entre 2.3 et 2.5.

Grâce à l'invention, sous l'effet une forte impulsion électrique, en particulier à l'étape d'initialisation, autrement appelée étape de forming, le matériau va se réorganiser pour créer une première zone et une deuxième zone présentant des compositions différentes. En effet, lors de l'initialisation, une partie du germanium Ge située dans la première zone Z1 est expulsée vers la deuxième zone Z2, de manière à appauvrir la première zone Z1 en germanium Ge, le rapport Sb/Te restant sensiblement identique dans la première zone Z1 et la deuxième zone Z2. Après initialisation, la première zone Z1 comprend un matériau appelé matériau Delta, constitué de 10.7% de germanium Ge, 62.7% d'antimoine Sb et de 26.6% de tellure Te et du germanium Ge en excès. Comme le matériau Delta présente une phase trigonale, voire hexagonale, il a une croissance cristalline plus rapide qu'un mélange ternaire classique, tel que le $Ge_2Sb_2Te_5$, qui lui cristallise en phase cubique et génère un phénomène de « drift » sur l'état SET très important, et n'est donc pas lui-même sujet au phénomène de « drift » pour l'état LRS ou SET. De plus, le matériau Delta a une température de cristallisation supérieure à 250°C.

Ainsi, une mémoire PCM présentant le matériau selon l'invention comme matériau actif a une température de cristallisation supérieure à 250°C et est non sujette au phénomène de « drift » pour son état LRS ou SET.

Outre les caractéristiques qui viennent d'être évoquées dans le paragraphe précédent, le matériau selon l'invention peut présenter une ou plusieurs caractéristiques complémentaires parmi les suivantes, considérées individuellement ou selon toutes les combinaisons techniquement possibles.

Selon une variante de réalisation compatible avec la variante de réalisation précédente, le rapport entre la quantité d'antimoine Sb et la quantité de tellure Te vaut sensiblement 2.4.

Selon une variante de réalisation compatible avec les variantes de réalisation précédentes, le matériau comporte entre 37% et 90% de germanium Ge, de préférence il comporte sensiblement 76% de germanium Ge.

Selon une variante de réalisation compatible avec les variantes de réalisation précédentes, le matériau comporte entre 65% et 80% de germanium Ge, entre 15% et 25% d'antimoine Sb et entre 5% et 11% de tellure Te.

Selon une variante de réalisation compatible avec les variantes de réalisation précédentes, le matériau comporte 76% de germanium Ge, 17%, d'antimoine Sb et 7% de tellure Te.

Selon une variante de réalisation compatible avec les variantes de réalisation précédentes, le matériau consiste en du germanium Ge, du tellure Te et de l'antimoine Sb, avec éventuellement au moins un dopant.

Selon une variante de réalisation compatible avec les variantes de réalisation précédentes, le matériau comporte au moins un dopant choisi parmi le groupe suivant : carbone C, titane Ti, oxygène O, phosphore P, arsenic As, bore B, gallium Ga ou silicium Si.

Ainsi, la croissance cristalline est davantage ralentie.

Selon une variante de réalisation compatible avec les variantes de réalisation précédentes, le matériau comporte au moins un dopant, le dopant étant de l'azote N.

Ainsi, la température de cristallisation est augmentée et l'état LRS ou SET est amélioré. En effet, l'azote N va se lier au germanium Ge et ainsi réduire la croissance d'agrégats de germanium Ge dans la zone active. Etant donné que le germanium Ge est un matériau très résistif indifféremment dans la phase LRS ou HRS de la mémoire 100, empêcher la formation d'agrégats de germanium Ge va avantager la croissance du matériau Delta qui est au contraire responsable du basculement entre l'état LRS ou SET et l'état HRS ou RESET.

Selon une première alternative de réalisation compatible avec les variantes de réalisation précédentes, le matériau se présente sous la forme d'un empilement de couches, avec chacune des couches ayant une épaisseur inférieure ou égale à 10 nm, de préférence inférieure ou égale à 5 nm.

Selon un premier exemple de réalisation de la première alternative, l'empilement comporte une première couche de $Ge_2Sb_2Te_5$, une deuxième couche d'antimoine Sb et une troisième couche de germanium Ge dopée avec de l'azote N.

Ainsi, les matériaux utilisés dans l'empilement de couches sont disponibles sur catalogue, son coût de fabrication est donc moindre.

Selon une variante de réalisation du premier exemple de réalisation, la première couche a une épaisseur sensiblement de 2.5 nm, la deuxième couche a une épaisseur sensiblement de 2.5 nm et la troisième couche a une épaisseur sensiblement de 10 nm.

Selon un deuxième exemple de réalisation, l'empilement de couches comporte une première couche de matériau comportant du germanium Ge, de l'antimoine Sb et du tellure Te, et une deuxième couche de germanium Ge dopée avec de l'azote N.

Ainsi, le dopage avec de l'azote N permet de maîtriser la croissance cristalline du germanium Ge et augmente ainsi la stabilité des couches, pour éviter une dégénération de la morphologie de l'empilement lors de la fusion.

Selon une variante de réalisation du deuxième exemple de réalisation, la première couche de matériau comporte entre 0% et 20% de germanium Ge, entre 50% et 70% d'antimoine Sb et entre 15% et 35% de tellure Te.

Selon une deuxième alternative de réalisation compatible avec les variantes de réalisation précédentes, le matériau se présente sous la forme d'une unique couche.

Un deuxième aspect de l'invention concerne une mémoire résistive à changement de phase comportant :

- une électrode supérieure ;
- une électrode inférieure ;
- au moins une couche active à partir du matériau selon l'invention ;

la mémoire étant destinée à passer d'un premier état résistif à un deuxième état résistif par application d'une tension ou d'un courant entre l'électrode supérieure et l'électrode inférieure.

Selon une variante de réalisation, la couche active, disposée entre l'électrode supérieure et l'électrode inférieure, présente une première zone définie autour d'un axe reliant le centre de l'électrode inférieure et le centre de l'électrode supérieure comprenant au moins une partie en un matériau constitué de 10.7% de germanium Ge, 62.7% d'antimoine Sb et de 26.6% de tellure Te, et une deuxième zone située autour et à l'extérieur de la première zone.

Un troisième aspect de l'invention concerne un procédé de fabrication de la mémoire selon l'invention, comportant les étapes réalisées dans l'ordre suivant :

- une étape de formation de l'électrode inférieure ;
- une étape de formation de la couche active de la mémoire ;
- une étape de formation de l'électrode supérieure.

Selon une variante de réalisation, l'étape de formation de la couche active comporte un dépôt d'une unique couche réalisée à partir du matériau selon l'invention ou comporte la formation d'un empilement de couches destiné à former au moins en partie le matériau selon l'invention.

Selon une variante de réalisation compatible avec la variante de réalisation précédente, le procédé comporte une étape d'application d'une impulsion électrique entre l'électrode supérieure et l'électrode inférieure, l'étape d'application de l'impulsion électrique étant mise en œuvre après les étapes de formation de l'électrode inférieure, de formation de la couche active, et de formation de l'électrode supérieure.

Selon une variante de réalisation compatible avec la variante de réalisation précédente, l'étape de formation de la couche active comporte au moins une sous-étape de pulvérisation cathodique utilisant au moins une cible de pulvérisation.

Selon une sous-variante de réalisation de la variante de réalisation précédente, la sous-étape de pulvérisation cathodique utilise au moins une cible de pulvérisation composée d'une molécule stable chimiquement à température ambiante, tel que par exemple une molécule de formule chimique $Ge_2Sb_2Te_5$.

La cible composée de la molécule de formule chimique $Ge_2Sb_2Te_5$ étant stable, son utilisation permet d'éviter la formation d'agrégats. De plus, cette cible étant disponible sur catalogue, son coût est moindre.

Selon un exemple de réalisation, la sous-étape de pulvérisation cathodique comprend au moins une cible de pulvérisation de formule chimique $Ge_2Sb_2Te_5$. Selon un exemple de réalisation, la sous-étape de pulvérisation cathodique comprend au moins une cible de pulvérisation constituée d'antimoine Sb. Selon un exemple de réalisation, la sous-étape de pulvérisation cathodique comprend au moins une cible de pulvérisation constituée de germanium Ge. Selon une réalisation, la sous-étape de pulvérisation cathodique est constituée par la pulvérisation d'une cible constituée de $Ge_2Sb_2Te_5$, d'une cible constituée d'antimoine Sb, et d'une cible constituée de germanium Ge.

Selon une sous-variante de réalisation de la variante de réalisation précédente, la sous-étape de pulvérisation cathodique utilise au moins une cible de pulvérisation composée d'une molécule stable chimiquement à température ambiante, tel que par exemple une molécule constituée de 10.7% de germanium Ge, 62.7% d'antimoine Sb et de 26.6% de tellure Te.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La figure 1 est un diagramme ternaire Ge-Sb-Te sur lequel est hachurée la zone proche des compositions possibles pour un matériau selon l'invention (ligne L2).
- La figure 2 montre une représentation schématique d'un premier mode de réalisation d'une mémoire selon l'invention.
- La figure 3 montre une représentation schématique d'un deuxième mode de réalisation d'une mémoire selon l'invention.
- La figure 4 est un schéma synoptique illustrant l'enchaînement des étapes d'un procédé de fabrication d'un dispositif selon l'invention.
- La figure 5 représente la résistivité en fonction de la température pour un matériau Delta enrichi de 11% en germanium, pour le matériau Delta enrichi de 35% en germanium, pour le matériau Delta enrichi de 49% en germanium, pour le matériau Delta enrichi de 64% en germanium et pour le matériau Delta enrichi de 70% en germanium.
- La figure 6 montre une diffractométrie par rayons X d'un matériau selon l'invention comportant 35% de germanium à 320°C, du matériau selon l'invention comportant 35% de germanium à 450°C, du matériau selon l'invention comportant 50% de germanium à 450°C, du matériau selon l'invention comportant 64% de germanium à 450°C et du matériau selon l'invention comportant 70% de germanium à 450°C.

**DESCRIPTION DETAILLEE**

Sauf précision contraire, un même élément apparaissant sur des figures différentes présente une référence unique.

Un premier aspect de l'invention concerne un matériau destiné à changer de phase pouvant être utilisé comme matériau actif d'une mémoire résistive à changement de phase ou mémoire PCM pour « Phase-Change Memory ».

Un deuxième aspect de l'invention concerne une mémoire résistive à changement de phase ayant pour matériau actif le matériau selon l'invention, c'est-à-dire comportant une zone active basée sur le matériau selon l'invention.

Le matériau selon l'invention comporte du germanium Ge, du tellure Te et de l'antimoine Sb.

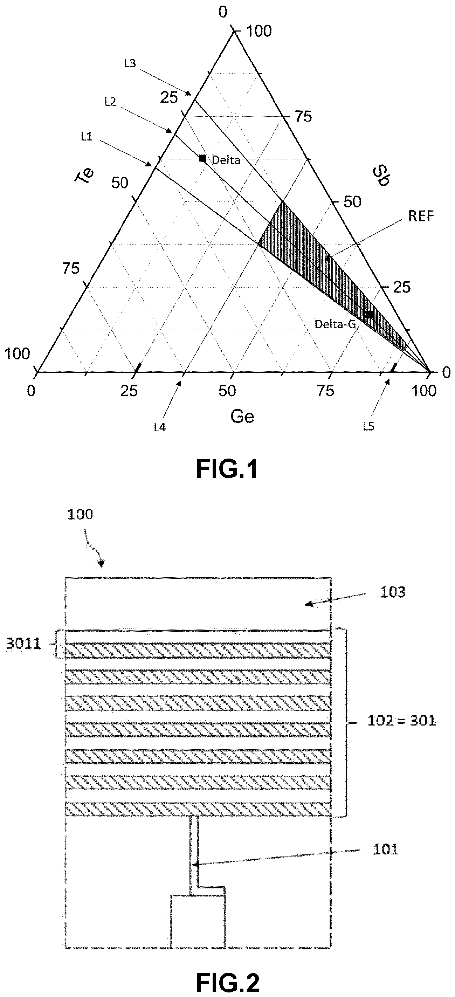

[Fig. 1] La figure 1 est un diagramme ternaire Ge-Sb-Te sur lequel est hachurée une zone REF proche des compostions possibles pour le matériau selon l'invention.

Le pourcentage utilisé tout le long de la description, est un pourcentage molaire, c'est-à-dire qu'on entend par « le matériau comporte au moins X% d'un élément », que la quantité de matière de l'élément dans le matériau correspond à X% de la quantité de matière totale du matériau, que ce soit avant ou après initialisation.

Dans la suite de la description, tous les pourcentages utilisés sont des pourcentages molaires.

Le matériau selon l'invention comporte au moins 37% de germanium Ge.

Lorsqu'il y a suffisamment de germanium Ge dans la zone active d'une mémoire PCM, celui-ci agit comme retardateur de la nucléation et de la croissance cristalline du matériau de la zone active, ce qui a pour effet d'augmenter la température de cristallisation de la zone active.

La mémoire PCM selon l'invention présentant le matériau selon l'invention comprenant au moins 37% de germanium Ge dans sa zone active a donc forcément une température de cristallisation de sa zone active supérieure à 250°C. Ainsi, pour des applications automobiles, ou pour des applications embarquées (« embedded » en anglais), il est assuré une préservation de l'information stockée dans la mémoire PCM selon l'invention.

Le matériau selon l'invention comporte par exemple entre 37% et 90% de germanium Ge.

Sur la figure 1, la ligne L4 représente 37% de germanium Ge, la ligne L5 représente 90% de germanium Ge et la zone hachurée REF est bornée par les lignes L4 et L5.

De préférence, le matériau selon l'invention comporte 76% de germanium Ge.

Le rapport entre la quantité d'antimoine Sb et la quantité de tellure Te dans le matériau selon l'invention est tel que :

$$1.5 \leq \frac{Sb}{Te} \leq 4$$

Sur la figure 1, la ligne L1 représente :

$$\frac{Sb}{Te} = 1.5$$

Sur la figure 1, la ligne L3 représente :

$$\frac{Sb}{Te} = 4$$

Le rapport entre la quantité d'antimoine Sb et la quantité de tellure Te dans le matériau peut être tel que :

$$2 \leq \frac{Sb}{Te} \leq 2.8$$

Le rapport entre la quantité d'antimoine Sb et la quantité de tellure Te dans le matériau selon l'invention est tel que :

$$2.3 \leq \frac{Sb}{Te} \leq 2.5$$

Autrement dit, le rapport entre la quantité d'antimoine Sb et la quantité de tellure Te dans le matériau selon l'invention vaut sensiblement 2.4.

Selon une réalisation, le rapport entre la quantité d'antimoine Sb et la quantité de tellure Te dans le matériau selon l'invention est strictement égal à 2.4.

Sur la figure 1, la ligne L2 représente :

$$\frac{Sb}{Te} = 2.4$$

Le matériau selon l'invention est par exemple une composition comportant entre 65% et 80% de germanium Ge, entre 15% et 25% d'antimoine Sb et entre 5% et 11% de tellure Te.

Préférentiellement, le matériau selon l'invention comporte 76% de germanium Ge, 17%, d'antimoine Sb et 7% de tellure Te, ce qui correspond au point Delta-G sur la figure 1.

Selon une réalisation particulière, le matériau selon l'invention peut comporter, en sus, au moins une espèce dopante.

On entend par « espèce dopante ou dopant d'un système », un élément chimique ne générant pas de liaisons covalentes avec le système, lorsque celui-ci est en phase cristalline. De préférence, la proportion de dopant au sein du système est inférieure à 15%, et encore plus préférentiellement entre comprise entre 1% et 10% ou entre 1% et 5%.

L'espèce dopante est par exemple du carbone C, du titane Ti, de l'oxygène O, du phosphore P, de l'arsenic As, du bore B, de l'azote N, du gallium Ga et/ou du silicium Si.

[Fig. 2] La figure 2 montre une représentation schématique d'un premier mode de réalisation de la mémoire 100 selon l'invention.

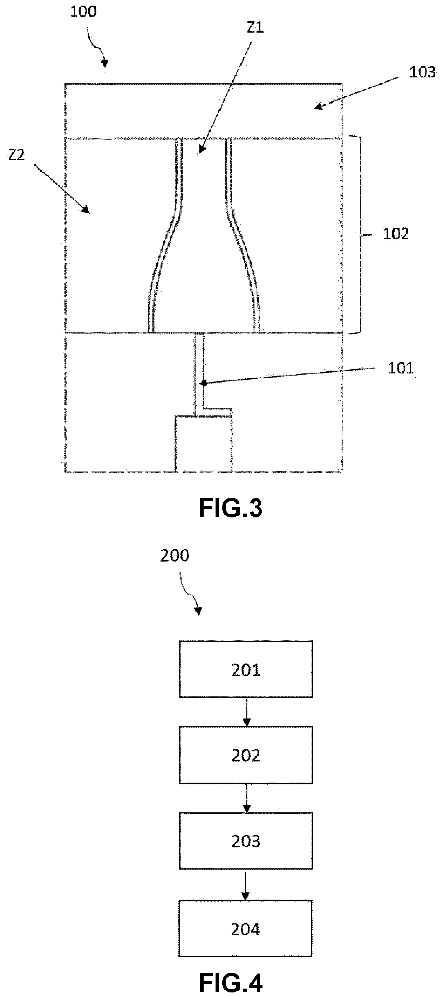

[Fig. 3] La figure 3 montre une représentation schématique d'un premier mode de réalisation de la mémoire 100 selon l'invention.

Quel que soit le mode de réalisation, la mémoire 100 comporte :

- une électrode inférieure 101 ;
- au moins une couche réalisée dans le matériau selon l'invention, dite couche active 102 ; et
- une électrode supérieure 103.

On définit une électrode supérieure d'un dispositif comme l'électrode située au-dessus de ce dispositif et l'électrode inférieure d'un dispositif comme l'électrode située en dessous de ce dispositif, les électrodes étant situées de part et d'autre du dispositif. Bien entendu, les adjectifs « supérieure » et « inférieure » sont ici relatifs à l'orientation de l'ensemble incluant l'électrode supérieure, le dispositif et l'électrode inférieure si bien qu'en retournant cet ensemble, l'électrode précédemment qualifiée de supérieure devient l'électrode inférieure et l'électrode précédemment qualifiée d'inférieure devient l'électrode supérieure. Pour autant, les adjectifs « supérieure » et « inférieure » ne limitent pas l'invention à la disposition des électrodes, le dispositif pouvant, bien entendu, subir une rotation de 90° de manière à être disposé verticalement.

L'électrode inférieure 101 et l'électrode supérieure 103 peuvent être planaires ou se présenter sous la forme d'un L ou d'un I.

Sur les figures 2 et 3, l'électrode inférieure 101 présente une forme en L et l'électrode supérieure 103 est planaire. En particulier, l'électrode inférieure 101 présente une forme en L avec une partie verticale plus importante que sa partie horizontale.

On entend par « électrode verticale », une électrode dont la dimension maximale est selon la direction verticale.

Les électrodes inférieure 101 et supérieure 103 sont réalisées chacune dans un matériau conducteur qui peut être différent ou le même pour les deux électrodes 101,103. Un tel matériau conducteur est par exemple du TiN, TaN, W, TiWN, TiSiN ou encore du WN.

Dans le premier mode de réalisation de la mémoire 100, la couche active 102 comporte un empilement 301 de couches, avant initialisation.

Chaque couche de l'empilement 301 de couches a une épaisseur inférieure ou égale à 10 nm, par exemple inférieure ou égal à 5 nm.

On entend par « épaisseur d'une couche », la dimension de la couche selon un axe perpendiculaire à un plan de couche, correspondant au plan formé par la couche. Ici, on associe l'axe en question à la direction verticale.

Dans un premier exemple de réalisation, l'empilement 301 de couches comporte par exemple au moins deux couches réalisées chacune dans un matériau différent, par exemple une première couche de $Ge_2Sb_2Te_5$, une deuxième couche d'antimoine Sb et une troisième couche de germanium Ge dopée avec de l'azote N.

La première couche a par exemple une épaisseur de 2.5 nm, la deuxième couche une épaisseur de 2.5 nm et la troisième couche une épaisseur de 10 nm.

Selon un deuxième exemple de réalisation, l'empilement 301 de couches comporte une première couche comportant entre 0% et 20% de germanium Ge, entre 50% et 70% d'antimoine Sb et entre 15% et 35% de tellure Te, et une deuxième couche de germanium Ge dopée avec de l'azote N.

Par exemple, l'empilement 301 de couches comporte une première couche de matériau Delta, c'est-à-dire comportant 10.7% de germanium Ge, 62.7%, d'antimoine Sb et 26.6% de tellure Te, ayant une épaisseur d'1 nm, et une deuxième couche de germanium Ge dopée avec de l'azote N ayant une épaisseur de 2.7 nm.

Quel que soit l'exemple de réalisation, la composition globale de l'empilement 301 de couches correspond à l'une des compositions décrites précédemment pour le matériau selon l'invention.

Sur la figure 2, l'empilement 301 de couches comporte une répétition de sept sous-empilements 3011 comportant chacun une première couche représentée en blanc faite dans un premier matériau et une deuxième couche représentée en hachuré faite dans un deuxième matériau.

Selon le deuxième mode de réalisation, la couche active 102 est formée par une unique couche composée du matériau selon l'invention.

L'unique couche a par exemple une épaisseur comprise entre 1 nm et 100 nm, de préférence une épaisseur supérieure ou égale à 10 nm.

Sur la figure 2, la mémoire 100 selon le premier mode de réalisation est représentée avant initialisation, c'est-à-dire avant d'avoir été soumise à une forte impulsion électrique.

Sur la figure 3, la mémoire 100 selon le deuxième mode de réalisation est représentée après initialisation, c'est-à-dire après avoir été soumise à une forte impulsion électrique.

Lors de l'étape d'initialisation de la mémoire 100 selon l'invention, une réorganisation de la zone active est mise en œuvre. Cette réorganisation, induite sous l'effet d'une forte impulsion électrique, a pour effet de créer deux zones au sein de la couche active 102, une première zone Z1 définie autour d'un axe reliant le centre de l'électrode inférieure 101 et de l'électrode supérieure 103 et une deuxième zone Z2 située autour et à l'extérieur de la première zone Z1. La première zone Z1 et la deuxième zone Z2 sont visibles sur la figure 3.

Sous l'effet de l'impulsion électrique d'initialisation, une partie du germanium Ge située dans la première zone Z1 est expulsée vers la deuxième zone Z2, de manière à appauvrir la première zone Z1 en germanium Ge. Cependant le rapport Sb/Te reste sensiblement identique dans la première zone Z1 et la deuxième zone Z2.

Après initialisation, la première zone Z1 comprend un matériau appelé Delta, représenté sur la figure 1, et du germanium Ge en excès.

Le matériau Delta est constitué de 10.7% de germanium Ge, 62.7% d'antimoine Sb et de 26.6% de tellure Te. Le matériau Delta est intéressant dans le sens où il a une phase cristalline trigonale, voire hexagonale, avec un taux de croissance cristalline très important assurant une forte uniformité cristalline, une faible résistivité, peu de joints de grains et pas de « drift ».

Le germanium Ge restant dans la première zone Z1 permet de retarder la nucléation et la croissance cristalline de la première zone Z1, ce qui a pour effet d'augmenter la température de cristallisation de la première zone Z1. Toutefois, le matériau Delta à lui seul, cristallise à une température inférieure à 250°C.

Il est à noter que dans sa globalité, le matériau de la couche active 102 présente les proportions énoncées plus haut avant et après initialisation de la mémoire 100.

Ainsi, l'étape d'initialisation induit une réorganisation du matériau mais n'en modifie pas sa composition. Dans la première zone Z1 et la deuxième zone Z2, le rapport entre Sb et Te reste sensiblement identique ; seul le germanium Ge est mobile au moment de l'initialisation.

Les différents rapports précédemment cités entre Sb et Te permettent de s'assurer qu'après initialisation, il est certain de retrouver, dans la première zone Z1, au moins une partie en matériau Delta, qui a pour effet d'induire une cristallinité de la première zone Z1 et au moins en partie à phase trigonale, plus particulièrement à phase hexagonale, ce qui présente comme avantage d'avoir une croissance cristalline favorisée par rapport à une phase cubique.

Suite à l'étape d'initialisation, le matériau de l'invention présentant l'antimoine Sb et le tellure Te dans les proportions précédemment décrites interagit avec le germanium Ge pour donner lieu à une nucléation permettant une cristallisation de la zone active dans une phase rhomboédrique ayant une croissance cristalline très importante. La taille et l'homogénéité d'une telle phase cristalline permet de réduire le phénomène de « drift » de l'état LRS ou SET.

Sur la figure 3, la mémoire 100 est représentée après initialisation, c'est-à-dire après avoir été soumise à une forte impulsion électrique, ce qui a entraîné une réorganisation du matériau, en le partageant en une première zone Z1 et une deuxième zone Z2. Il est à noter que le même partage s'opère pour le premier mode de réalisation. La fusion d'une partie de la couche active 102 permet donc de définir la première zone Z1. La fusion a lieu autour d'un axe reliant le centre de l'électrode inférieure 101 et de l'électrode supérieure 103. Selon l'exemple illustré, l'électrode inférieure 101 et l'électrode supérieure 103 sont chacune positionnées l'une en regard de l'autre. Selon une variante de réalisation, l'électrode inférieure 101 et l'électrode supérieure 103 pourraient ne pas être disposées en regard l'une de l'autre, mais en décalage. Dans ce cas, la première zone Z1 se présenterait sous la forme d'une diagonale. Dans tous les cas, la deuxième zone Z2 est située autour de cet axe central, à l'extérieur de la première zone Z1.

Le dopage à l'azote N permet d'augmenter la température de cristallisation de la zone active de la mémoire 100 selon l'invention et d'améliorer son état LRS ou SET. En effet, l'azote N va se lier au germanium Ge et ainsi réduire la croissance d'agrégats de germanium Ge dans la zone active. Etant donné que le germanium Ge est un matériau très résistif indifféremment dans la phase LRS ou HRS de la mémoire 100, empêcher la formation d'agrégats de germanium Ge va avantager la croissance de la phase Delta qui est au contraire responsable du basculement entre l'état LRS ou SET et l'état HRS ou RESET.

Un troisième aspect de l'invention concerne un procédé de fabrication de la mémoire 100 selon l'invention.

[Fig. 4] La figure 4 est un schéma synoptique illustrant l'enchaînement des étapes du procédé 200 selon le troisième aspect de l'invention.

Une première étape 201 consiste à former l'électrode inférieure 101 de la mémoire 100. Par exemple, pour obtenir une électrode inférieure 101 planaire, la première étape 201 consiste à réaliser un dépôt conforme d'une couche de matériau conducteur d'électrode inférieure 101 sur un substrat.

On entend par « dépôt conforme d'une couche de matériau sur un substrat » que le matériau est déposé de manière uniforme sur l'ensemble de la surface du substrat.

Le substrat peut comprendre une ou de plusieurs couches : il comprend, par exemple, une couche avec des lignes en cuivre exposées permettant d'établir des contacts métalliques avec une couche métallique supérieure et comprend ainsi toute la logique nécessaire pour permettre la connexion avec les lignes des couches supérieures.

Une deuxième étape 202 du procédé 200 consiste à former la couche active 102.

Dans le premier mode de réalisation de la mémoire 100, la deuxième étape 202 consiste à former l'empilement 301 de couches.

Dans le deuxième mode de réalisation, la deuxième étape 202 consiste à former l'unique couche constituant la couche active 102.

Quel que soit le mode de réalisation, la deuxième étape 202 comporte par exemple au moins un dépôt, par exemple un dépôt physique en phase vapeur ou dépôt PVD (pour « Physical Vapor Deposition »), ou au moins une pulvérisation cathodique en utilisant au moins une cible de pulvérisation composée d'une molécule stable chimiquement à température ambiante.

La deuxième étape 202 utilise par exemple au moins une cible de pulvérisation composée de la molécule de formule chimique $Ge_2Sb_2Te_5$.

La deuxième étape 202 utilise par exemple au moins une cible de pulvérisation composée de la molécule de formule chimique $Ge_2Sb_2Te_5$ et une cible de pulvérisation composée d'antimoine Sb ou de germanium Ge.

La deuxième étape 202 utilise par exemple au moins une cible de pulvérisation composée de la molécule Delta.

D'autres étapes intermédiaires peuvent être réalisées entre la deuxième étape 202 et la troisième étape 203 du procédé 200, par exemple la formation d'un dispositif sélecteur entre l'électrode inférieure 101 et la couche active 102 ou entre la couche active 102 et l'électrode supérieure 103.

Une troisième étape 203 du procédé 200 consiste à former l'électrode supérieure 103 de la mémoire 100.

La troisième étape 103 consiste par exemple à réaliser un dépôt conforme d'une couche de matériau conducteur d'électrode supérieure 103, par exemple sur la couche active 102.

Le procédé 200 selon l'invention peut également comporter une quatrième étape 204 facultative d'application d'une impulsion électrique entre l'électrode supérieure 103 et l'électrode inférieure 101, correspondant à l'initialisation de la mémoire 100.

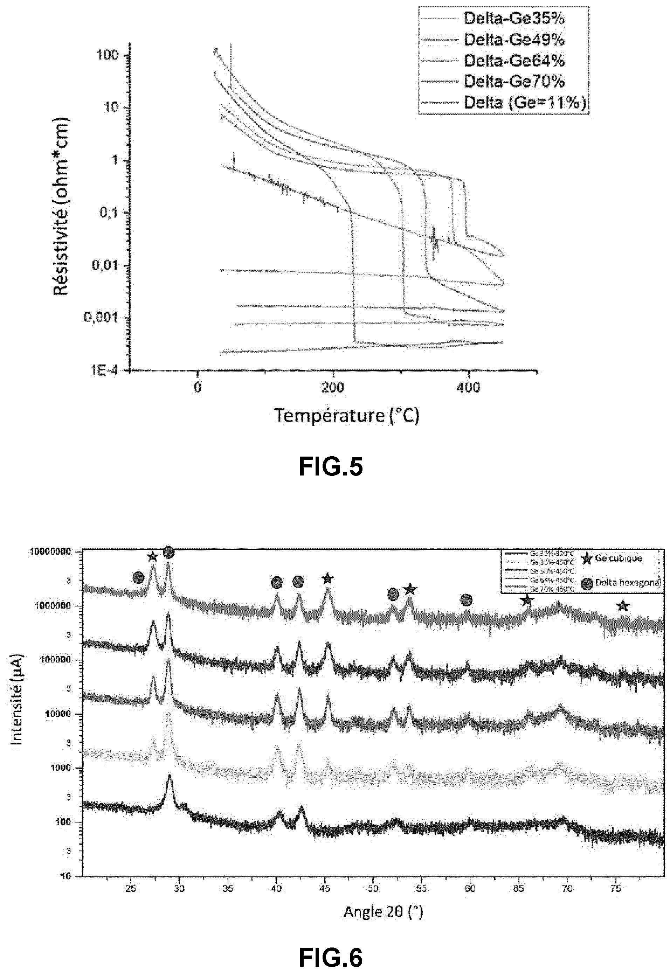

[Fig. 5] La figure 5 représente la résistivité en fonction de la température pour le matériau Delta enrichi de 11% en germanium, pour le matériau Delta enrichi de 35% en germanium, pour le matériau Delta enrichi de 49% en germanium, pour le matériau Delta enrichi de 64% en germanium et pour le matériau Delta enrichi de 70% en germanium.

On constate sur la figure 5 que plus la quantité de germanium est grande, plus d'une part, la cristallisation du matériau Delta est réalisée à une température élevée et plus d'autre part, la cristallisation du matériau Delta se fait de manière abrupte, c'est-à-dire plus la courbe devient verticale de manière abrupte, le caractère abrupte de la cristallisation étant synonyme d'une cristallisation très rapide, due à la vitesse de croissance très importante, typique de la phase « Delta ».

[Fig. 6] La figure 6 montre une diffractométrie par rayons X d'un matériau selon l'invention comportant 35% de germanium à 320°C, du matériau selon l'invention comportant 35% de germanium à 450°C, du matériau selon l'invention comportant 50% de germanium à 450°C, du matériau selon l'invention comportant 64% de germanium à 450°C et du matériau selon l'invention comportant 70% de germanium à 450°C, dans laquelle sont identifiées les valeurs de 2θ correspondant à du germanium cristallisé en phase cubique et du matériau Delta cristallisé en phase hexagonale.

On constate sur la figure 6 que quel que soit le pourcentage de germanium, le matériau comprend à chaque fois du germanium cristallisé en phase cubique et du matériau Delta cristallisé en phase hexagonale à 450°, tandis qu'à 320°C, le matériau comprend uniquement du matériau Delta cristallisé en phase hexagonale.

Ainsi, on retrouve bien à 450°C une première partie en matériau Delta cristallisé en phase hexagonale et une deuxième partie en germanium cristallisé en phase cubique.

## Revendications

1. Matériau destiné à changer de phase comportant du germanium Ge, du tellure Te et de l'antimoine Sb, **caractérisé en ce qu'**il comporte au moins 37% de germanium Ge et **en ce que** le rapport entre la quantité d'antimoine Sb et la quantité de tellure Te est compris entre 2.3 et 2.5.

2. Matériau selon la revendication 1, **caractérisé en ce qu'**il comporte entre 37% et 90% de germanium Ge, de préférence il comporte sensiblement 76% de germanium Ge.

3. Matériau selon l'une quelconque des revendications précédentes, **caractérisé en ce qu'**il comporte entre 65% et 80% de germanium Ge, entre 15% et 25% d'antimoine Sb et entre 5% et 11% de tellure Te, de préférence il comporte 76% de germanium Ge, 17% d'antimoine Sb et 7% de tellure Te.

4. Matériau selon l'une quelconque des revendications précédentes, **caractérisé en ce qu'**il consiste en du germanium Ge, du tellure Te, et de l'antimoine Sb, avec éventuellement au moins un dopant.

5. Matériau selon l'une quelconque des revendications précédentes, **caractérisé en ce qu'**il comporte au moins un dopant choisi parmi le groupe suivant : azote N, carbone C, titane Ti, oxygène O, phosphore P, arsenic As, bore B, gallium Ga ou silicium Si.

6. Matériau selon l'une quelconque des revendications précédentes, **caractérisé en ce qu'**il se présente sous la forme d'un empilement (301) de couches, avec chacune des couches ayant une épaisseur inférieure ou égale à 10 nm, de préférence inférieure ou égale à 5 nm.

7. Matériau selon la revendication 6, **caractérisé en ce que** l'empilement (301) comporte une première couche de $Ge_2Sb_2Te_5$, une deuxième couche d'antimoine Sb et une troisième couche de germanium Ge dopée avec de l'azote N.

8. Matériau selon la revendication 6, **caractérisé en ce que** l'empilement (301) de couches comporte une première couche de matériau comportant du germanium Ge, de l'antimoine Sb et du tellure Te, et une deuxième couche de germanium Ge dopée avec de l'azote N.

9. Matériau selon l'une quelconque des revendications 1 à 5, **caractérisé en ce qu'**il se présente sous la forme d'une unique couche.

10. Mémoire (100) résistive à changement de phase comportant :

    - une électrode supérieure (103) ;
    - une électrode inférieure (101) ;
    - au moins une couche active (102) réalisée à partir du matériau défini selon l'une quelconque des revendications précédentes ;

    la mémoire (100) étant destinée à passer d'un premier état résistif à un deuxième état résistif par application d'une tension ou d'un courant entre l'électrode supérieure (103) et l'électrode inférieure (101).

11. Mémoire (100) selon la revendication précédente, **caractérisée en ce que** la couche active (102), disposée entre l'électrode supérieure (103) et l'électrode inférieure (101), présente une première zone (Z1) définie autour d'un axe reliant le centre de l'électrode inférieure (101) et le centre de l'électrode supérieure (103) comprenant au moins une partie en un matériau constitué de 10.7% de germanium Ge, 62.7% d'antimoine Sb et de 26.6% de tellure Te, et une deuxième zone (Z2) située autour et à l'extérieur de la première zone (Z1).

12. Procédé (200) de fabrication de la mémoire (100) définie selon l'une quelconque des revendications 10 ou 11, **caractérisé en ce qu'**il comporte les étapes réalisées dans l'ordre suivant :

  - une étape (201) de formation de l'électrode inférieure (101) ;
  - une étape (202) de formation de la couche active (102) ;
  - une étape (203) de formation de l'électrode supérieure (103).

13. Procédé (200) selon la revendication 12, **caractérisé en ce que** l'étape (202) de formation de la couche active (102) comporte un dépôt d'une unique couche réalisée à partir du matériau défini selon la revendication 9 ou comporte la formation d'un empilement de couches destiné à former au moins en partie le matériau défini selon l'une quelconque des revendications 6 à 8.

14. Procédé de fabrication (200) selon la revendication 12 ou 13, **caractérisé en ce qu'**il comporte une étape (204) d'application d'une impulsion électrique entre l'électrode supérieure (103) et l'électrode inférieure (101), l'étape d'application de l'impulsion électrique étant mise en œuvre après les étapes (201, 202, 203) de formation de l'électrode inférieure (101), de formation de la couche active (102), et de formation de l'électrode supérieure (103).

**Patentansprüche**

1. Material zum Phasenwechsel, das Germanium Ge, Tellur Te und Antimon Sb enthält, **dadurch gekennzeichnet, dass** es mindestens 37 % Germanium Ge enthält und dass das Verhältnis zwischen der Menge an Antimon Sb und der Menge an Tellur Te zwischen 2,3 und 2,5 liegt.

2. Material nach Anspruch 1, **dadurch gekennzeichnet, dass** es zwischen 37% und 90% Germanium Ge enthält, vorzugsweise enthält es im Wesentlichen 76% Germanium Ge.

3. Material nach einem der vorhergehenden Ansprüche, **dadurch gekennzeichnet, dass** es zwischen 65% und 80% Germanium Ge, zwischen 15% und 25% Antimon Sb und zwischen 5% und 11% Tellur Te enthält, vorzugsweise enthält es 76% Germanium Ge, 17% Antimon Sb und 7% Tellur Te.

4. Material nach einem der vorhergehenden Ansprüche, **dadurch gekennzeichnet, dass** es aus Germanium Ge, Tellur Te und Antimon Sb besteht, gegebenenfalls mit mindestens einem Dotierstoff.

5. Material nach einem der vorhergehenden Ansprüche, **dadurch gekennzeichnet, dass** es mindestens einen Dotierstoff enthält, der aus der folgenden Gruppe ausgewählt ist: Stickstoff N, Kohlenstoff C, Titan Ti, Sauerstoff O, Phosphor P, Arsen As, Bor B, Gallium Ga oder Silizium Si.

6. Material nach einem der vorhergehenden Ansprüche, **dadurch gekennzeichnet, dass** es in Form eines Schichtenstapels (301) vorliegt, wobei jede der Schichten eine Dicke von weniger als oder gleich 10 nm, vorzugsweise von weniger als oder gleich 5 nm, aufweist.

7. Material nach Anspruch 6, **dadurch gekennzeichnet, dass** der Stapel (301) eine erste Schicht aus $Ge_2Sb_2Te_5$, eine zweite Schicht aus Antimon Sb und eine dritte Schicht aus Germanium Ge, die mit Stickstoff N dotiert ist, umfasst.

8. Material nach Anspruch 6, **dadurch gekennzeichnet, dass** der Schichtenstapel (301) eine erste Schicht aus einem Material mit Germanium Ge, Antimon Sb und Tellur Te und eine zweite Schicht aus Germanium Ge, die mit Stickstoff N dotiert ist, umfasst.

9. Material nach einem der Ansprüche 1 bis 5, **dadurch gekennzeichnet, dass** es in Form einer einzigen Schicht vorliegt.

10. Resistiver Phasenwechselspeicher (100) mit:

  - einer oberen Elektrode (103);
  - einer unteren Elektrode (101);
  - mindestens einer aktiven Schicht (102), die aus dem Material hergestellt ist, das nach einem der vorhergehenden Ansprüche definiert ist;

wobei der Speicher (100) dazu bestimmt ist, von einem ersten resistiven Zustand in einen zweiten resistiven Zustand überzugehen, indem zwischen der oberen Elektrode (103) und der unteren Elektrode (101) eine Spannung oder ein Strom angelegt wird.

11. Speicher (100) nach dem vorhergehenden Anspruch, **dadurch gekennzeichnet, dass** die aktive Schicht (102), die zwischen der oberen Elektrode (103) und der unteren Elektrode (101) angeordnet ist, einen ersten Bereich (Z1) aufweist, der um eine Achse definiert ist, die die Mitte der unteren Elektrode (101) und die Mitte der oberen Elektrode (103) verbindet, und der mindestens einen Teil aus einem Material umfasst, das aus 10,7% Germanium Ge, 62,7% Antimon Sb und 26,6% Tellur Te besteht, und einen zweiten Bereich (Z2), der sich um den ersten Bereich (Z1) herum und außerhalb von diesem befindet.

12. Verfahren (200) zur Herstellung des Speichers (100), der nach einem der Ansprüche 10 oder 11 definiert ist, **dadurch gekennzeichnet, dass** es die in der folgenden Reihenfolge ausgeführten Schritte umfasst:

- einen Schritt (201) zum Bilden der unteren Elektrode (101);
- einen Schritt (202) zum Bilden der aktiven Schicht (102);
- einen Schritt (203) zum Bilden der oberen Elektrode (103).

13. Verfahren (200) nach Anspruch 12, **dadurch gekennzeichnet, dass** der Schritt (202) zur Bildung der aktiven Schicht (102) ein Auftragen einer einzelnen Schicht umfasst, die aus dem nach Anspruch 9 definierten Material hergestellt wird, oder die Bildung eines Schichtenstapels umfasst, der dazu bestimmt ist, zumindest teilweise das nach einem der Ansprüche 6 bis 8 definierte Material zu bilden.

14. Herstellungsverfahren (200) nach Anspruch 12 oder 13, **dadurch gekennzeichnet, dass** es einen Schritt (204) des Anlegens eines elektrischen Impulses zwischen der oberen Elektrode (103) und der unteren Elektrode (101) umfasst, wobei der Schritt des Anlegens des elektrischen Impulses nach den Schritten (201, 202, 203) der Bildung der unteren Elektrode (101), der Bildung der aktiven Schicht (102), und der Bildung der oberen Elektrode (103) durchgeführt wird.

**Claims**

1. Phase-change material comprising germanium Ge, tellurium Te and antimony Sb, **characterised in that** it comprises at least 37% germanium Ge and **in that** the ratio between the quantity of antimony Sb and the quantity of tellurium Te is comprised between 2.3 and 2.5.

2. Material according to claim 1, **characterised in that** it comprises between 37% and 90% germanium Ge, preferably it comprises substantially 76% germanium Ge.

3. Material according to any preceding claim, **characterised in that** it comprises between 65% and 80% germanium Ge, between 15% and 25% antimony Sb and between 5% and 11% tellurium Te, preferably it comprises 76% germanium Ge, 17% antimony Sb and 7% tellurium Te.

4. Material according to any preceding claim, **characterised in that** it consists of germanium Ge, tellurium Te, and antimony Sb, with optionally at least one dopant.

5. Material according to any preceding claim, **characterised in that** it comprises at least one dopant chosen from the following group: nitrogen N, carbon C, titanium Ti, oxygen O, phosphorus P, arsenic As, boron B, gallium Ga or silicon Si.

6. Material according to any preceding claim, **characterised in that** it has the form of a stack (301) of layers, with each one of the layers having a thickness less than or equal to 10 nm, preferably less than or equal to 5 nm.

7. Material according to claim 6, **characterised in that** the stack (301) comprises a first layer of $Ge_2Sb_2Te_5$, a second layer of antimony Sb and a third layer of germanium Ge doped with nitrogen N.

8. Material according to claim 6, **characterised in that** the stack (301) of layers comprises a first layer of material comprising germanium Ge, antimony Sb and tellurium Te, and a second layer of germanium Ge doped with nitrogen N.

9. Material according to any of claims 1 to 5, **characterised in that** it has the form of a single layer.

10. Resistive phase-change memory (100) comprising:

- an upper electrode (103);
- a lower electrode (101);
- at least one active layer (102) made from a material defined according to any preceding claim;

the memory (100) being intended to pass from a first resistive state to a second resistive state by application of a voltage or of a current between the upper electrode (103) and the lower electrode (101).

11. Memory (100) according to the preceding claim, **characterised in that** the active layer (102), disposed between the upper electrode (103) and the lower electrode (101), has a first zone (Z1) defined about an axis connecting the centre of the lower electrode (101) and the centre of the upper electrode (103) comprising at least one portion made from a material consisting of 10.7% germanium Ge, 62.7% antimony Sb and 26.6% tellurium Te, and a second zone (Z2) located around and outside of the first zone (Z1).

12. Method (200) for manufacturing memory (100) defined according to any of claims 10 or 11, **characterised in that** it comprises the steps carried out in the following order:

   - a step (201) of forming the lower electrode (101);
   - a step (202) of forming the active layer (102);
   - a step (203) of forming the upper electrode (103).

13. Method (200) according to claim 12, **characterised in that** the step (202) of forming the active layer (102) comprises a deposition of a single layer made from a material defined according to claim 9 or comprises the formation of a stack of layers intended to form at least partially the material defined according to any of claims 6 to 8.

14. Method of manufacturing (200) according to claim 12 or 13, **characterised in that** it comprises a step (204) of applying an electrical pulse between the upper electrode (103) and the lower electrode (101), the step of applying an electrical pulse being implemented after the steps (201, 202, 203) of forming the lower electrode (101), of forming the active layer (102), and of forming the upper electrode (103).

**FIG.1**

**FIG.2**

100

Z1

103

Z2

102

101

# FIG.3

200

201

202

203

204

# FIG.4

FIG.5

FIG.6

**EP 3 940 803 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013187111 A1